# EUROPÄISCHE PATENTANMELDUNG

(11) **EP 0 875 724 A2**
(43) Veröffentlichungstag der Anmeldung: **04.11.1998**
(21) Anmeldenummer: 98250145.4
(22) Anmeldetag: 29.04.1998
(51) Int. Cl.: F24J 2/06

(54) **Vorrichtung zur Lichtsammlung,-Konzentrierung und -Leitung von direkter und diffuser Strahlung**

(30) Priorität: 30.04.1997 DE 19719083
(71) Anmelder: Kokoschko, René, 15566 Schöneiche (DE)
(72) Erfinder: Kokoschko, Alf, 15566 Schöneiche (DE); Kokoschko, Björn, 15566 Schöneiche (DE); Kokoschko, Ute, 15566 Schöneiche (DE); Kokoschko, Rene, 15566 Schöneiche (DE)

(57) **Zusammenfassung**

Die Erfindung betrifft eine Vorrichtung zur Lichtsammlung, -konzentrierung und -leitung von direkter und diffuser Strahlung, in dem erfindungsgemäß die in einem bestimmten Winkelbereich über der ersten Oberfläche (2) in die Vorrichtung eintretende direkte und diffuse Strahlung einer Quelle durch Verminderung der Divergenz und der parallelen Ausrichtung des Lichtes mittels reflektiver (5,6,9) und refraktiver (4,7,10) Elemente dem Akzeptanzwinkels bzw. dem Winkel der Totalreflektion des Lichtleiters angepaßt wird.

## Beschreibung

Obwohl die solare Strahlung jahreszeitlich und witterungsbedingt starken Schwankungen unterworfen ist, beträgt die jährlich in Mitteleuropa eingestrahlte Energie etwa 1000 kWh/m², in der Sahara 2500 kWh/m². [Wissenspeicher Solartechnik, VEB Fachbuchverlag Leipzig 1984, S.16]
Die gegenwärtig am häufigsten eingesetzte Nutzung der solaren Strahlungsenergie zur direkten Wärmegewinnung ist die Niedrigtemperaturerzeugung in Gewächshäusern und in Wohngebäuden. Eine weitere Niedrigtemperaturanwendung erfolgt mit Solarsystemen, deren aktives Element ein Sonnenkollektor (auch Solarabsorber oder Energieabsorber) ist. In diesem Kollektor wird die auftreffende Globalstrahlung, also die Summe der direkten Sonnenstrahlung und diffusen Himmelsstrahlung, in Wärme umgewandelt. Der Absorptionsfaktor gibt die Umwandlungseffizienz der auf die Absorberoberfläche auftreffenden Strahlung an. In der Regel beträgt der Absorptionsfaktor 0,9. D.h. neunzig Prozent der eingestrahlten Solarenergie wird in Wärme umgewandelt, diese in ein Medium, im allgemeinen eine Flüssigkeit oder ein Gas, übertragen und über das Medium zum Anwendungsort transportiert.
Ein Nachteil dieser Anlagen besteht in einem hohen Aufwand für den Transport der absorbierten Wärmemenge zum Ort des Verbrauches. Da der Transport in den seltensten Fällen durch den Schweretransport realisiert werden kann, ist der Einsatz von Umwälzpumpen, also ein zusätzlicher Energieeinsatz, notwendig. Ein weiterer Nachteil dieser auf flachen Sonnenkollektoren basierenden Anlagen ist der sinkende Wirkungsgrad mit dem Ansteigen der Temperatur im Kollektor.
In Ländern mit intensiver Sonneneinstrahlung wird die Sonnenenergie für die Erzeugung von Temperaturen > 200 °C genutzt. Das aktive Element solcher Anlagen sind spezielle Kollektoren, die das einfallende Sonnenlicht über optische Elemente wie Spiegel oder Linsen auf eine Absorberoberfläche konzentrieren.
Der wesentliche Nachteil dieser Anlagen ist die ständig notwendige Ausrichtung des Brennpunktes auf die Absorberoberfläche. Zudem lassen sich mit diesen Kollektoren nur die direkte Sonnenstrahlung (parallel ausgerichtete Strahlung) fokussieren.
Gegenwärtig sind strahlenfokussierende Systeme für Mitteleuropa wenig interessant, da bisherige Systeme sich ausschließlich auf die Konzentrierung der direkten Sonnenstrahlung beschränken. Tatsächlich beträgt in den Breiten Mitteleuropas der Anteil des diffus am Himmel gestreuten Sonnenlichtes an der Globalstrahlung je nach Jahreszeit 50 bis 70 % [Heinz Ladener, 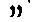 Solaranlagen", Ökobuch Verlag Staufen bei Freiburg, 1996, S. 10]. Somit wird mit diesen Anlagen ein großer Teil des solaren Energieangebotes nicht genutzt.
In der DE 32 11 339 A1 wird eine Solaranlage beschrieben, in der mit konzentrierenden Elementen wie Spiegeln und Fresnellinsen das Sonnenlicht auf einen Brennfleck in der Brennebene fokussiert wird. Zwischen dem Brennfleck und dem Energiewandler befindet sich ein das 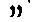 konzentrierte Sonnenlicht einkoppelnder optischer Aufnahmekegel", der das Sonnenlicht aufnimmt. Über Lichtleitfasern wird das Licht zu dem Energiewandler geleitet. Nachteil dieser Anlage ist die ständig notwendige Nachführung der Konzentratoren entsprechend dem Sonnenstand und der nur geringe Anteil der diffusen Himmelsstrahlung an der gesamten Strahlungsausbeute, da diffuse Strahlung mit den herkömmlichen Mitteln der abbildenden Optik, wenn, dann nur zu geringen Anteilen konzentriert werden kann.

In der DE 27 36 907 A1 wird eine Vorrichtung zur Leitung von Strahlungsenergie beschrieben, die es ermöglicht, direkte und diffuse Sonnenstrahlung eines großen Winkelbereiches zu erfassen und diese durch die Einstrahlungsrichtung und die unter einem durch die Form der reflektierenden Wände definierten Winkel auf eine Absorberfläche zu lenken. Mit der Verwendung dieser Strahlungslenkvorrichtung entfällt die Ausrichtung der technischen Anlage nach dem aktuellen Sonnenstand. Es muß nur eine jahreszeitlich bedingte Ausrichtungsänderung vorgenommen werden. Nachteilig für eine Einkopplung in ein lichtleitendes Element für den Weitertransport der Strahlungsenergie ist die erfindungsgemäß gewählte Position des für die Lage der reflektierenden parabolischen Wände notwendigen Brennpunktes.

In der DE 27 09 284 A1 wird eine weitere Vorrichtung zum Konzentrieren von Strahlungsenergie beschrieben. Diese Vorrichtung hat den Zweck, den auf eine Absorberfläche auftreffenden Strahlungswinkel auf einen Winkelbereich gleich oder kleiner 90° an der Austrittsöffnung zu beschränken. Vordergründig ist damit die Steigerung der Konzentration des eingestrahlten Sonnenlichtes und der Effizienz der Absorptionsvorgänge an der Oberfläche eines an der Austrittsfläche angeordneten Energieabsorbers beabsichtigt.

Eine Verwendung dieser bekannt gewordenen Vorrichtungen zur Einkopplung von Sonnenstrahlung in Lichtleiter ist auf Grund des heutigen Erkenntnisstandes kaum möglich, da die mit diesen Vorrichtungen erzeugte Strahlqualität für die effiziente Einkopplung und den Transport in dem Lichtleiter nicht genügt.

Die dabei für die Einkopplung von Licht in Lichtleitfasern häufig verwendeten Miniaturkugellinsen genügen der Anforderung, Laserlicht, aber nicht diffuse Sonnenstrahlung, in eine Faser einzukoppeln.

Erfindungsaufgabe ist die Sammlung des direkten und diffusen Anteils der Strahlung einer Quelle mit einem größtmöglichen Winkel in einer Vorrichtung, die Konzentrierung und Verringerung der Divergenz und der Schiefe der Strahlung unter möglichst wenig Reflexionen an reflektierenden Wänden mit der Verwendung refraktiver Elemente in einen Lichtleiter, damit die Strahlung ohne zusätzlichen Leistungsaufwand den Ort des Energieeinsatzes erreichen kann.

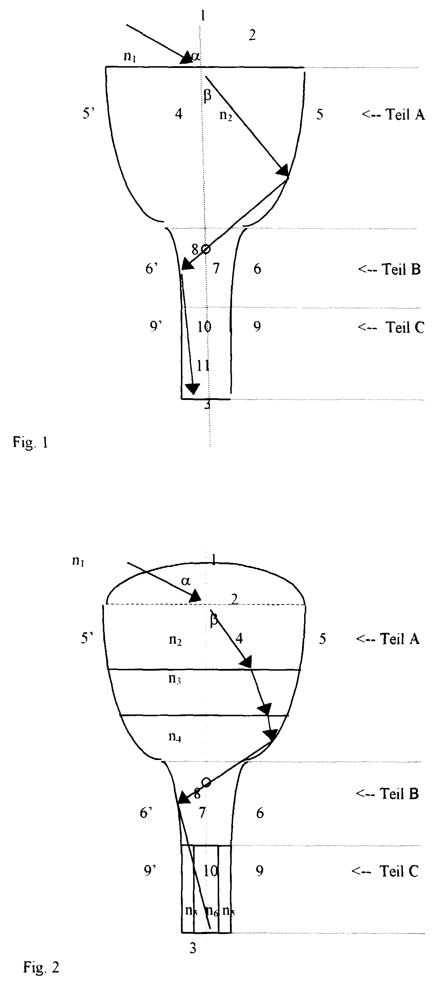

Erfindungsgemäß wird die Aufgabe mit einer in der Figur 1 dargestellten nicht abbildenden Vorrichtung gelöst, indem die in einem bestimmten Winkelbereich über der ersten Oberfläche in die Vorrichtung eintretende direkte und diffuse Strahlung einer Quelle durch Verminderung der Divergenz, der Schiefe und der parallelen Ausrichtung des Lichtes mittels reflektiver und refraktiver Elemente dem Akzeptanzwinkels bzw. dem Winkel der Totalreflektion des Lichtleiters angepaßt wird.

Gemäß Figur 1 besteht die erfindungsgemäße Vorrichtung aus insgesamt drei Teilen (Teil A, B und C). Nimmt man eine Minderung der Eigenschaften der Vorrichtung hin, so kann die Vorrichtung auch aus zwei Teilen (Teil A und C) bestehen , mit einer besonderen Gestaltung des Teiles A. Diese drei Teile sind entlang einer ersten Symmetrieachse (1) nacheinander angeordnet. Die Figur 1 zeigt die Vorrichtung im Schnitt in einer Ebene, die die Symmetrieachse enthält. Durch eine Drehung der Symmetrieachse um 360° wird ein dreidimensionaler Körper umschrieben, der von oben gesehen eine kreisförmige Eintrittsfläche die Oberfläche (2) hat. Der in Richtung der Symmetrieachse (1) betrachtete Querschnitt der Teile A und B, angefangen bei der Oberfläche (2) ist kreisförmig, rund, elliptisch, bevorzugt polyedrisch oder deieckig und hat einen abnehmenden Querschnitt bis zur Lichtleitung im Teil C.
Ein weiteres Merkmal der Vorrichtung ist, daß die Oberfläche (2) der Vorrichtung gerade, sphärisch oder asphärisch gewölbt ist und somit über eine Vorrichtung zur Strahlenfokussierung in Form einer Linse verfügt. Dabei sind die refraktiven Elemente (4, 7 und 10) für die zu sammelnde Strahlung in der Vorrichtung optimal transparent, d.h. insbesondere in Bereichen des spektralen Bereiches von 250 bis 10000 nm.
Im Teil A, dem Absorber, wird der refraktive Körper (4) von der Eintrittsoberfläche (2), die senkrecht zur Symmetrieachse (1) angeordnet ist, von den reflektierenden Wänden (5' und 5) und dem Übergang zu dem Teil B begrenzt. Der Brennpunkt (8) für die Konstruktion der reflektierenden Wände (5' und 5) kann im unteren Bereich des Teils A oder auf der Symmetrieebene im Teil B liegen. In der Figur 1 ist der Brennpunkt im Teil B eingezeichnet.

Im Teil B wird der refraktive Körper (7) von oben vom Teil A, von den Seiten von den reflektierenden Wänden (6' und 6) und von unten vom Teil C begrenzt.

Im Teil C, dem Lichtleiter, wird der refraktive Körper (10) von oben vom Teil B, von den Seiten von den reflektierenden Wänden (9' und 9) und von unten von der Austrittsfläche (3), die senkrecht zur Symmetrieachse (1) angeordnet ist, begrenzt. Der refraktive Körper 10 der Lichtleitung besteht aus mindestens zwei parallel zur Symmetrieachse (1) liegenden Schichten, im dreidimensionalen Raum betrachtet Zylindern, bzw. gefüllten Hohlzylindern mit unterschiedlichen Brechungsindizes. Dabei ist der Brechungsindex der auf der Symmetrieebene liegenden Teils der Lichtleitung am größten. Die Lichtleitung die an den Teil B angrenzt kann an der Oberfläche verspiegelt und als Kapillare ausgebildet sein.

Für die Darlegung der Funktionsweise der Erfindung werden nur Meridionalstrahlen, d.h. Strahlen, die in der Ebene den Kern der Lichtleitfaser, die also die Symmetrieachse (1) enthalten, berücksichtigt. Über die Oberfläche (2) des Teils A tritt Strahlung in die Vorrichtung ein. Diese Strahlung trifft diffus aus dem gesamten Halbraum auf die Oberfläche (2). Dabei nimmt der Betrag der durch eine ebene transparente Glasplatte durchgelassenen direkten Sonnenstrahlung von einem Winkel von 70° zum Zenit bis zu einem Winkel von 90° zum Zenit von rund 70% auf Null Prozent ab. Für eine Nutzung der Sonnenstrahlung mit einer Einrichtung, die fest installiert ist, muß für die Vermeidung von jahreszeitlich bedingten Ausrichtungen diese über einen möglichst großen Aufnahmewinkel für die Strahlung der Sonne verfügen. Die Verwendung einer sphärisch und oder asphärisch gewölbten Oberfläche (2) ist somit sinnvoll.

Die über die Oberfläche (2) des Teils A in die Vorrichtung eingetretene Strahlung wird im refraktiven Element (4) gebrochen, über die reflektierende Wände (5' und 5) auf das Teil B gerichtet, dort im refraktiven Element (7) sowie über die reflektierenden Wände (6' und 6) weiter konzentriert und weitestgehend parallel zur Symmetrieachse (1) ausgerichtet, um so spätestens im Teil C in eine Lichtleitung eingekoppelt und weitergeleitet zu werden, um über den Lichtleiter des Teiles C die Vorrichtung zu verlassen.

Der für die Konstruktion der reflektierenden Wände (5' und 5) des Teils A notwendige Brennpunkt (8) liegt auf der Symmetrieachse (1) im unteren Bereich des Teils A und/oder im Teil B. Die Form der reflektierenden Wände (5' und 5), (6' und 6) und (9' und 9) werden durch Kegelschnitte, Geraden und Spiralen mathematisch beschrieben.
Die Übergänge zwischen den Teilen A und B sowie zwischen dem Teil B und C sind glatt. Die Seitenwände reflektieren das in die Vorrichtung eingefallene Licht durch eine aufgetragene metallische Schicht, oder durch die Ausrichtung der Seitenwände in Bezug auf den durch den Winkel (α) erfolgenden Lichteinfall nach dem Prinzip der Totalreflektion.
Mit der Anordnung und der Ausrichtung der reflektierenden Wände (5' und 5) des Teiles A, der Gestaltung des Überganges der reflektierenden Seitenwand vom Teil A zum Teil B und der Zusammensetzung des refraktiven Elementes (4) des Teils A, das im einfachsten Fall homogen ist und auf der Symmetrieachse (1) in Richtung des Teils B optisch dichter wird, wobei die Veränderung des Brechungsindexes graduiert oder stufenförmig erfolgen kann, wird bewirkt, daß die über die Oberfläche (2) in die Vorrichtung eintretende Strahlung in einem definierten Winkel in den Teil B reflektiert wird. Dieser Winkel ist kleiner als der oder gleich dem Akzeptanzwinkel der Lichtleitung, wenn die Strahlung in die vordere Fläche des Lichtleiters eintritt.

Der Übergang der reflektierenden Seitenwand vom Teil A zum Teil B ist so gestaltet, daß das auf diese Teile der reflektierenden Wände auttreffende Licht in einem Winkel reflektiert wird, der kleiner oder gleich dem Akzeptanzwinkel der Lichtleitung ist. Hierdurch ist eine möglichst verlusffreie Weiterleitung der Strahlungsenergie möglich.

Der Verlauf der Strahlung im Teil B erfolgt durch die Eigenschaften des refraktiven Elements (7) mit der Verlängerung des Lichtleiters in den Teil B der Vorrichtung durch den Wechsel des Brechungsindex parallel zur Richtung der Symmetrieachse (1) und symmetrisch zu den spiegelnd reflektierende Wände (6' und 6). Im Teil B wird die Strahlung weiter konzentriert und parallel der Symmetrieachse (1) ausgerichtet, um so spätestens im Teil C in die Lichtleitung mit einem Winkel eingestrahlt zu werden, der kleiner als der Akzeptanzwinkel der Lichtleitung ist. Dabei kann im einfachsten Fall die Vorrichtung im Teil A und dem Teil B aus einem Material mit einem Brechungsindex beschaffen sein. Dabei bestimmt der Brechungsindex dieses Materials die Größe des Winkels (α) und damit den maximal verwertbaren Aufnahmewinkel für die Strahlung der Sonne.

Ein weiteres Merkmal der Erfindung ist, daß die Lichtleitung des Teils C entlang der Symmetrieachse (1) über den Teil B in das refraktive Element (4) des Teils A hineinragt und sich bis zur Oberfläche (2) erstrecken kann und entlang der Symmetrieachse (1) symmetrisch zu den reflektierenden Wänden (5) und (5') des Teils A und den reflektierenden Wänden (6) und (6*'*) des Teils B oder auch symmetrisch zur Symmetrieachse (1) ausgerichtet wird und somit einen wichtigen Teil des refraktiven Elementes (4) des Teils A und des refraktiven Elementes (7) des Teils B bildet. Dieser Lichtleiter im Teil A, B und C kann über mehrere, mindestens aber über zwei zur Symmetrieachse (1) parallel angeordnete oder symmetrisch zu den reflektierenden Wänden (5) und (5') des Teils A und den reflektierenden Wänden (6) und (6*'*) des Teils B, angeordnete Schichten mit jeweils verschiedenen Brechungsindizes verfügen und diese steigen in Richtung senkrecht auf die Symmetrieachse (1) zu an, wobei der Lichtleiter aber auch die Form einer Kapillare haben kann. In Verbindung mit der Wahl des Querschnittes der Oberfläche (2), wird mit der Gestaltung der Dicke der symmetrisch zu den reflektierenden Wänden oder zur Symmetrieachse (1) ausgerichteten brechenden Schichten, ein Einfluß zur Verminderung der Schiefe bewirkt.
Zur Verringerung der Divergenz , der bereits im Teil A in den verlängerten Lichtleiter eintretenden Strahlung, wird im refraktiven Element (4) ein im Querschnitt gesehen, ein Dreieck, mit einer Spitze an und oder unter der Oberfläche (2), zwischen den Wänden (5' und 5) angebracht das sich entlang der Symmetrieachse (1) in Richtung des Teiles C erstreckt und mit einer Fläche senkrecht zur Symmetrieachse (1) direkt an die Lichtleitung angrenzt, oder der Lichtleiter vom Teil C bis zur Oberfläche (2) des Teils A spitz ausläuft, wobei der Brechungsindex dieses refraktiven Elementes im Teil A und im Teil B höher als der Brechungsindex des umgebenden Materials ist.

Es ist auch möglich, mehrere erfindungsgemäße Vorrichtungen zur großflächigen Energiesammlung nebeneinader zu reihen. Dabei ist es von Vorteil, wenn die obere begrenzende Eintrittsfläche (2) eine von oben in Richtung der Symmetrieachse (1) betrachtet sechseckige Form hat. Zudem kann die Anordnung dieser Elemente in einer Ebene oder in Form einer sphärischen Oberfläche erfolgen.

Im Folgendem wird die Erfindung anhand der Zeichnungen erläutert. Sie zeigen
- Fig. 1:: Darstellung der Vorrichtung mit Anzeige des Strahlungsverlaufes,
- Fig. 2:: Darstellung der Vorrichtung mit verschiedenen Brechungsindizes des refraktiven Elementes des Teils A,
- Fig. 3:: Aufbau der Vorrichtung mit einem Lichtleiter im Teil A und B,
- Fig. 4:: Aufbau der Vorrichtung mit einem Kegel im Teil A und B,

Die Figur 2 zeigt ein weiteres Ausführungsbeispiel der Erfindung, wobei die Oberfläche (2) konvex dargestellt wird und die erfindungsgemäße Vorrichtung mit einem nicht homogenen Aufbau des refraktiven Elementes (4) des Teiles A. Die Vorrichtung befindet sich in einem Medium mit dem Brechungsindex n₁. Das refraktive Element wird entlang der Symmetrieachse (1) und in Richtung des Teils B in der Reihe n₂<n₃<n₄ optisch dichter. Dabei kann die Veränderung des Brechungsindex graduiert oder stufenförmig erfolgen. In der Figur 2 ist die Veränderung der Brechungsindizes stufenförmig dargestellt. Die Wirkung der Erhöhung des Brechungsindex ist eine Verringerung der Divergenz der Strahlung in der Vorrichtung. Der Weg der Strahlung in der Vorrichtung erfolgt so mit einem kleinerem Winkel zur Symmetrieachse. Der Verlauf der Strahlung verläuft analog wie in der Figur 1 dargestellt, nur das die Strahlung stärker durch das refraktive Element (4) des Teils A gebrochen wird.

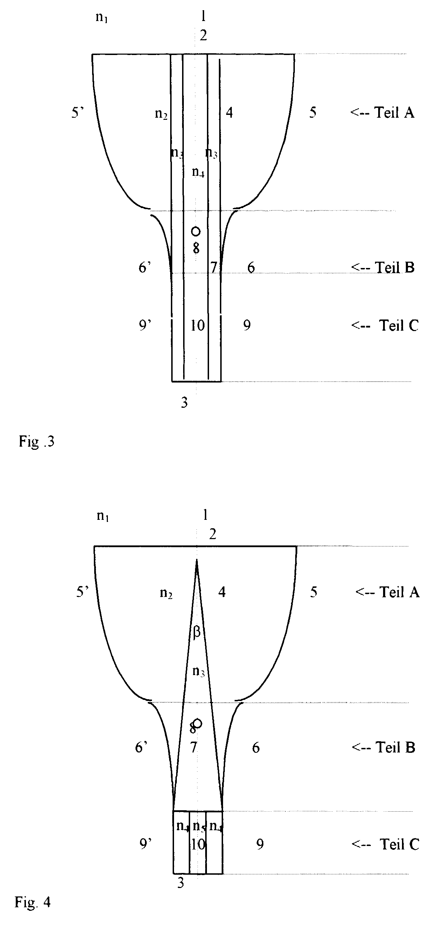

Die Figur 3 zeigt ein weiteres Ausführungsbeispiel der Erfindung. Dargestellt ist der Aufbau der erfindungsgemäßen Vorrichtung mit einem Lichtleiter im Teil A. Die Lichtleitung des Teils C kann sich entlang der Symmetrieachse (1) über den Teil B in das refraktive Element (4) des Teils A bis zur Oberfläche (2) erstrecken. Die Lichtleitung ist in der Symmetrieachse (1) symmetrisch zu den reflektierenden Wänden (5' und 5) ausgerichtet und bildet so einen wichtigen Teil des refraktiven Elementes 4 des Teils A. Die Lichtleitung kann mit mehreren, mindestens aber zwei zur Symmetrieachse (1) parallel angeordnete Schichten mit jeweils verschiedenen Brechungsindizes aufgebaut sein, die senkrecht zur Symmetrieachse (1) ansteigen.
Die in das refraktive Element (4) des Teiles A eingetretene Strahlung wird, wenn die Strahlung in der Meridianebene liegt und die Lichtleitung mit einem Winkel kleiner als die durch die Brechungsindizes festgelegten Winkel der Totalreflektion schneidet, in den Lichtleiter weitergeleitet. Ist der Winkel größer als der Winkel der Totalreflektion oder wird der Lichtleiter nicht geschnitten, wird die Strahlung von den reflektierenden Wänden (5' und 5), (6' und 6) oder (9' und 9) mit einem Winkel kleiner als dem Winkel der Totalreflektion in den Lichtleiter eingekoppelt und dort über den Mechanismus der Totalreflektion weitergeleitet. Somit wird mit der erfindungsgemäßen Vorrichtung im Gegensatz zu der von Winston und Rabe vorgeschlagenen Vorrichtung, die durch die Reflexion an den Seitenwänden erfolgende Konzentrierung der Strahlung auf einer Fläche zum Ziel hatte, die Transformation der Strahlung über die Einkopplung dieser durch die Seitenfläche eines Lichtleiters auf einen 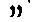 Linienfokus" realisiert. Die Strahlungsenergie kann so über die Oberfläche eines gebildeten Zylinders in den Lichtleiter eingekoppelt werden.

In der Figur 4 ist ein weiteres Ausführungsbeispiel der Erfindung dargestellt. Sie zeigt den Aufbau der Vorrichtung mit einem Kegel im refraktiven Element (4 ) des Teiles A. Im Querschnitt gesehen ist dieser Kegel ein Dreieck, das mit einer Spitze an oder unter der Oberfläche (2) im Teil A zwischen den Wänden (5' und 5) angebracht ist. Es erstreckt sich entlang der Symmetrieachse (1) in Richtung des Teiles C und grenzt in der Figur mit einer Fläche senkrecht zur Symmetrieachse (1) direkt an die Lichtleitung.
Der Kegel kann direkt an der Fläche des beginnenden Lichtleiters anlegen oder in einem Abstand zum Lichtleiter im Teil B oder in der Nähe der Grenze zum Teil B im Teil A enden. Der Brechungsindex dieses refraktiven Elementes im Teil A und im Teil B kann dabei höher oder niedriger als der Brechungsindex des umgebenden Materials sein. In der dargestellten Figur 4 ist der Brechungsindex des Kegels größer als der des umgebenden Materials und bildet einen wichtigen Teil des refraktiven Elementes (4) des Teils A und des refraktiven Elementes (7) des Teiles B.
Die in das refraktive Element (4) des Teiles A gelangte Strahlung wird, wenn die Strahlung in der Meridianebene liegt und den Kegel in einem Winkel schneidet, bei dem Eintritt in den Kegel dort entsprechend dem veränderten Brechungsindex gebrochen und zur gegenüberliegenden Wand des Kegels geleitet. Ist der Winkel der auf diese innere Wand des veränderten Brechungsindexes kleiner als der durch die Brechungsindizes festgelegten Winkel der Totalreflektion, dann wird die Strahlung im Kegel mit einem veränderten Winkel weitergeleitet. Das bewirkt eine Veränderung der Divergenz der einfallenden Strahlung. Der Winkel der Strahlung zur Symmetrieachse (1) wird kleiner, die Strahlung wird 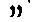 parallelisiert" und so den Erfordernissen für eine verlustfreie Weiterleitung der Strahlung im Lichtleiter angepaßt. Ist der Winkel größer als der Winkel der Totalreflektion oder wird der Kegel nicht geschnitten, wird die Strahlung von den spiegelnd reflektierenden Wänden (5' und 5), (6' und 6) oder (9' und 9) mit einem Winkel kleiner als dem Winkel der Totalreflektion in den Kegel eingekoppelt und dort über den Mechanismus der Totalreflektion weitergeleitet. Somit kann mit der Verwendung eines Kegels mit einem anderem Brechungsindex als das umgebende transparente Material des refraktiven Elementes (4) des Teils A und des refraktiven Elementes (7) des Teils B, die Divergenz der in diesen Kegel gelangenden Strahlung elegant verändert werden und die Fläche, über die die Strahlung in das lichtleitende Element eintreten kann, wird weiter vergrößert.

### Aufstellung der Bezugszeichen

- 1.: Symmetrieachse
- 2.: Oberfläche
- 3.: Austrittsfläche
- 4.: refraktives Element des Teils A
- 5' und 5.: reflektierende Seitenwände des Teils A
- 6' und 6.: reflektierende Seitenwände des Teils B
- 7.: refraktives Element des Teils B
- 8.: Brennpunkt für die Konstruktion des Teils A
- 9' und 9.: reflektierende Seitenwände des Teils C
- 10.: refraktives Element des Teils C
- 11.: Brennpunkt für die Konstruktion des Teils B

## Patentansprüche

1. Vorrichtung zur Lichtsammlung, -konzentrierung und -leitung von direkter und diffuser Strahlung einer Quelle mittels reflektierender und refraktiver Elemente, wobei das Material der refraktiven Elemente für die Ausbreitung der Strahlung wenigstens in einem Teil des Wellenlängenbereiches von 250 bis 10000 nm transparent ist, dadurch gekennzeichnet, daß die Vorrichtung aus drei Teilen (Teil A, B und C) besteht, wobei diese Teile entlang einer ersten Symmetrieachse (1) nacheinander angeordnet sind, und die Strahlung durch die Oberfläche (2) des Teiles A in die Vorrichtung eintritt und über den Lichtleiter des Teiles C wieder verläßt, indem die in das Teil A eingetretene Strahlung im refraktiven Element (4) sowie über die reflektierenden Wände (5' und 5) in das Teil B gerichtet wird und dort im refraktiven Element (7) sowie über die reflektierenden Wände (6' und 6) weiter konzentriert und weitestgehend parallel der Symmetrieachse (1) ausgerichtet wird, um so spätestens im Teil C dort im refraktiven Element (10) sowie über die reflektierenden Wände (9' und 9) in eine Lichtleitung eingekoppelt und weitergeleitet zu werden, und wobei der für die Konstruktion der reflektierende Wände (5' und 5) des Teils A notwendige Brennpunkt (8) auf der Symmetrieachse (1) im unteren Bereich des Teils A und/oder im Teil B angeordnet ist und wobei der für die Konstruktion der reflektierende Wände (6' und 6) des Teils B notwendige Brennpunkt (11) auf der Symmetrieachse (1) angeordnet ist, um mit der Ausrichtung der Seitenwände die von der Oberfläche (2) in die Vorrichtung eintretende Strahlung unter einen Winkel in den Teil B zu lenken, und daß der Übergang der reflektierenden Seitenwand vom Teil A zum Teil B so gestaltet wird, daß das auf diese Teile der reflektierenden Wände auftreffende Licht in einem Winkel reflektiert wird, der kleiner als der Akzeptanzwinkel der Lichtleitung ist, wenn die Strahlung in die vordere innere Oberfläche des Lichtleiters eintritt, oder mit einem Winkel der kleiner ist als der Winkel der Totalreflektion, wenn die Strahlung in den mit einem Winkel der die Symmetrieachse in einem Winkel scheidet in die Lichtleitung eintritt, die Strahlung wird im Teil B durch die spezielle Gestaltung des Wechsels des Brechungsindex in Richtung der Symmetrieachse (1) und symmetrisch zu den reflektierende Wände (6' und 6) des refraktiven Elementes (7) sowie über die Form der reflektierende Wände (6' und 6) weiter konzentriert und parallel der Symmetrieachse (1) ausgerichtet, um so spätestens im Teil C in die Lichtleitung mit einem Winkel eingestrahlt zu werden, daß ein von einer Strahlungsquelle ausgehender Strahl mit einem Winkel kleiner als mit dem bestimmten Winkel (α) durch die Vorrichtung in Form eines dreidimensionalen Körpers in seinem Strahlungsweg so verändert wird, daß er von einer Lichtleitung aufgenommen und weitergeleitet wird.

2. Vorrichtung nach Anspruch 1, dadurch gekennzeichnet, daß der in Richtung der Symmetrieachse (1) betrachtete Querschnitt der Teile A und B, angefangen bei der Oberfläche (2), kreisförmig, rund, elliptisch, polyedrisch oder deieckig ist und über einen abnehmenden Querschnitt bis zur Lichtleitung im Teil C verfügt und daß die Oberfläche (2) der Vorrichtung gerade, sphärisch oder asphärisch gewölbt ist und/ oder aus einer Anordnung zur Sammlung oder Fokussierung von Strahlung besteht.

3. Vorrichtung nach Anspruch 1 dadurch gekennzeichnet, daß die reflektierenden Seitenwände (5' und 5) des Teils A, die Seitenwände (6' und 6) des Teils B, die Seitenwände des Übergang des Teils A zum Teil B sowie die Seitenwände des Überganges des Teils B zum Teil C durch eine metallische Schicht spiegelnd reflektieren und/oder an den Seitenwänden das auftreffende Licht total reflektieren, und die Form der reflektierenden Seitenwände der Teile A und B im Querschnitt senkrecht zur Symmetrieachse (1) betrachtet, elliptisch, parabolisch, hyperbolisch, spiralförmig oder geradlinig ist und der für die Konstruktion der Seitenwände (5' und 5) des Teils A notwendige Brennpunkt (8) auf der Symmetrieachse (1) im unteren Bereich des Teils A und/oder im Teil B liegt und die Neigung in jedem Punkt der reflektierenden Seitenwände (5' und 5) des Teils A, abgestimmt wird auf den Winkel des durch das refraktive Element gebrochenen Strahles des mit dem größtmöglichen Winkel zur Symmetrieachse (1) in die Oberfläche (2) eintretenden Strahls, so daß spätestens im Teil C der Strahl in die Lichtleitung mit einem Winkel eingestrahlt wird, daß ein jeder von der Strahlungsquelle ausgehender Strahl mit einem Winkel kleinerer als mit dem bestimmten Winkel (α) durch die Vorrichtung in seinem Strahlungsweg so verändert wird, daß er von einer Lichtleitung aufgenommen und weitergeleitet wird, der Übergang der reflektierenden Seitenwand vom Teil A zum Teil B ist so gestaltet, daß das auf diese Teile der reflektierenden Wände auftreffende Licht in einem Winkel reflektiert wird, der kleiner als der Akzeptanzwinkel bzw. des Winkels der Totalreflektion der Lichtleitung ist, die Strahlung im Teil B durch die spezielle Gestaltung des Wechsels des Brechungsindex in Richtung der Symmetrieachse (1) und symmetrisch zu den reflektierende Wände (6' und 6) des refraktiven Elementes (7) sowie über die Form der reflektierende Wände (6' und 6) weiter konzentriert und parallel der Symmetrieachse (1) ausgerichtet wird, um so spätestens im Teil C in die Lichtleitung mit einem Winkel eingestrahlt zu werden, der kleiner ist als der Winkel der Totalreflektion der Lichtleitung, der für die Konstruktion der Seitenwände (6' und 6) des Teils B notwendige Brennpunkt (11) liegt auf der Symmetrieachse (1) im Teil B der unmittelbar an den Teil C angrenzt oder auf der Symmetrieachse (1) in Richtung des Lichtleiters C liegt und oder im Teil C, und das die Neigung in jedem Punkt der reflektierenden Seitenwände (6' und 6) des Teils B, abgestimmt wird auf den größten Winkel des durch das refraktive Element (4) des Teils A gebrochen Strahls, so daß spätestens im Teil C der Strahl in die Lichtleitung mit einem Winkel trifft, so daß ein jeder von der Strahlungsquelle ausgehender Strahl mit einem Winkel kleinerer als mit dem bestimmten Winkel (α) durch die Vorrichtung in seinem Strahlungsweg so verändert wird, daß er von einer angepaßten Lichtleitung aufgenommen und weitergeleitet wird.

4. Vorrichtung nach Anspruch 1, dadurch gekennzeichnet, daß das refraktive Element (4) des Teils A homogen oder inhomogen ist, und daß das refraktive Element (4) des Teils A in Richtung der Symmetrieachse (1) und in Richtung des Teils B optisch dichter wird, dabei erfolgt die Veränderung des Brechungsindexes graduiert oder stufenförmig.

5. Vorrichtung nach Anspruch 1 und 4, dadurch gekennzeichnet, daß die Lichtleitung des Teils C entlang der Symmetrieachse (1) über den Teil B in das refraktive Element (4) des Teils A hineinragt und sich bis zur Oberfläche (2) erstrecken kann und entlang der Symmetrieachse (1) symmetrisch zu den reflektierenden Wänden (5) und (5') des Teils A und den reflektierenden Wänden (6) und (6') des Teils B und/oder symmetrisch zur Symmetrieachse (1) ausgerichtet wird und so einen wichtigen Teil des refraktiven Elementes 4 des Teils A und des refraktiven Elementes 7 des Teils B bildet.

6. Vorrichtung nach Anspruch 1, 4 und 5 dadurch gekennzeichnet, daß der Lichtleiter im Teil A, B und C über mehrere, mindestens aber über zwei zur Symmetrieachse (1) parallel angeordnete und/oder symmetrisch zu den reflektierenden Wänden (5) und (5') des Teils A und den reflektierenden Wänden (6) und (6*'*) des Teils B, angeordnete Schichten mit jeweils verschiedenen Brechungsindizes verfügt und diese in Richtung senkrecht auf die Symmetrieachse (1) zu ansteigen, wobei der Lichtleiter auch die Form einer Kapillare haben kann.

7. Vorrichtung nach Anspruch 1, 4, 5 und 6 dadurch gekennzeichnet, daß im Teil A des refraktiven Elementes (4) ein im Querschnitt gesehen, ein Dreieck, mit einer Spitze an und oder unter der Oberfläche (2) im Teil A, zwischen den Wänden (5' und 5) angebracht ist und sich entlang der Symmetrieachse (1) in Richtung des Teiles C erstreckt und mit einer Fläche senkrecht zur Symmetrieachse (1) direkt an die Lichtleitung angrenzt, und/oder der Lichtleiter vom Teil C bis zur Oberfläche (2) des Teils A spitz ausläuft, wobei der Brechungsindex dieses refraktiven Elementes im Teil A und im Teil B höher als der Brechungsindex des umgebenden Materials ist.

8. Vorrichtung nach Anspruch 1 und 2, dadurch gekennzeichnet, daß die Vorrichtung mit den reflektierenden Seitenwänden (5' und 5) des Teils A sowie den reflektierenden Seitenwänden (6' und 6) des Teils B symmetrisch oder unsymmetrisch aufgebaut ist.

9. Vorrichtung nach Anspruch 1, 2, 3, 4, 5, 6 und 7 dadurch gekennzeichnet, daß eine Anzahl dieser Vorrichtungen nebeneinander angeordnet werden und diese sich in einer Ebene oder in Form einer sphärischen Oberfläche befinden und daß die Enden der Lichtleiter zusammen in lichtleitende Kapillaren gesteckt werden oder über spezielle Kopplungen der Lichtleiter für den Weitertransport der Strahlungsenergie mit einander verbunden werden.
